Europäisches Patentamt

European Patent Office

Office européen des brevets

(11) Publication number: **0 257 792**
**A2**

# (12) EUROPEAN PATENT APPLICATION

(21) Application number: **87306471.1**

(22) Date of filing: **22.07.87**

(51) Int. Cl.⁴: **H05K 3/02**

(30) Priority: **01.08.86 US 893027**

(43) Date of publication of application:
**02.03.88 Bulletin 88/09**

(84) Designated Contracting States:
**DE FR GB IT**

(71) Applicant: **BRENT CHEMICALS**
**INTERNATIONAL PLC**
**Ridgeway**
**Iver Buckinghamshire SL0 9JJ(GB)**

(72) Inventor: **Schiller, Harold**
**3321 Greenbrier Road**
**Long Beach California 90808(US)**

(74) Representative: **Lawrence, Peter Robin**
**Broughton et al**
**GILL JENNINGS & EVERY 53-64 Chancery**
**Lane**
**London WC2A 1HN(GB)**

(54) Composition and method for stripping films from printed circuit boards.

(57) An aqueous solution of nitric acid, ferric nitrate and sulphamic acid may be used as a single stage stripping composition for stripping solder and the underlying tin-copper alloy from the copper substrate of a printed circuit board.

EP 0 257 792 A2

Xerox Copy Centre

## Composition and Method for Stripping Films from Printed Circuit Boards

This invention relates to a composition and method for the removal of solder films from printed circuit boards and, in particular, for stripping the solder film and the underlying tin-copper alloy from the copper substrate of a printed circuit board.

A typical printed circuit board has a copper conductor pattern on an insulating support. Solder is applied on to the copper substrate, typically by electroplating. The solder film typically is in the order of 0.008mm thick which is the standard thickness used in most present day processes. This is a nominal value, for the thickness may vary considerably over the board and from board to board. After the solder film is applied on to the copper, a thin film of copper-tin alloy forms between the copper and the solder, typically about 0.00005 to 0.0001mm thick. This copper-tin alloy film increases in thickness with time.

As used in the specification and claims, the word "solder" includes the various tin-lead alloys and substantially pure tin as used in providing films on printed circuit boards. Such films are produced by various methods, including electro-plating, chemical deposition and immersion in a melt. While the 60-40 tin-lead solder film typically is about 0.008 to 0.01mm thick, the pure tin film typically is about 0.005mm thick. The film is used as a resist over the copper during etching of the copper in the production of solder mask over bare copper boards.

In the manufacturing process the solder film is stripped from the copper substrate. Two types of compositions have been used for this solder stripping in the past. One composition is an acid solution of hydrogen peroxide and a fluoride. The other stripper is a nitric acid solution inhibited so that it will not attack copper. In general, the nitric acid based solder strippers are superior to the peroxide-fluoride based strippers, and have been used commercially for a number of years.

The peroxide-fluoride compositions are undesirable because there is an exothermic reaction during the stripping which heats the solution to a temperature which decomposes the unstable peroxide and makes the solution unusable. Hence the solution requires cooling during use. Also, the peroxide-fluoride solutions are slower in operation than the nitric acid solutions and have a toxicity problem.

The conventional nitric acid stripper system for removing solder and the underlying alloy from a printed circuit board requires two baths with different compositions of solutions, and two application steps in the stripping process. The nitric acid solution is maintained in a tank and the board is immersed in the solution for a period of time required to dissolve the solder. Following removal of the solder, it is necessary to remove the tin-copper alloy layer to expose the copper substrate. This is achieved by then immersing the board in a second tank containing another solution which dissolves the tin-copper alloy and ordinarily a small amount of the pure copper substrate. This second solution may be for example, ferric chloride, ammonium persulfate, peroxide sulfuric acid, or peroxide-fluoride.

In U.S. 3,367,874 it is stated that the rate of dissolution of nickel, copper, zinc, cobalt or iron by nitric acid can be accelerated by including, inter alia, sulphamic acid. In U.S. 3,349,036 it is stated that the corrosiveness of dilute nitric acid to iron and aluminium can be reduced by including sulphamic acid.

In U.S. 2,872,302 the rate of etching of copper by a chromic-sulphuric acid solution is increased by including ferric nitrate in the solution. In U.S. 3,015,630 a nickel coating is stripped off a base metal by a stripping solution comprising nitric acid and sulphuric acid and, as an inhibitor to reduce corrosion of the base metal, a nitrate salt. Ferric nitrate is shown to give some reduction in corrosion of the base metal but the more effective nitrates are nitrates of silver, magnesium, cobalt, aluminium and nickel.

Clearly none of these very old patents are relevant to the outstanding problem of trying to provide a stripping composition that can strip both the solder and the underlying copper alloy off a printed circuit board in a single step. In particular it would be desirable to be able to achieve this stripping in a single step by applying the composition by spray or dip at ambient temperature and in a short time.

A composition according to the invention for removal of solder from the copper substrate of a printed circuit board comprises an aqueous solution of nitric acid and is characterised in that it also removes the underlying tin-copper alloy from the copper substrate and the solution also contains ferric nitrate and sulphamic acid.

The nitric acid must be present in an amount sufficient to dissolve the solder and this generally requires that it is present in an amount of at least 5 volume percent and preferably at least 10 volume percent, measured as 69% nitric acid aqueous solution.

The ferric nitrate must be present in an amount sufficient to dissolve tin-copper alloy and this generally requires that it is present in an amount of at least 1 volume percent and preferably at least 5 volume percent, measured as 45% aqueous solution.

The sulphamic acid should be present in an amount sufficient to react with and eliminate nitrous acid that is initially present and/or is formed during the stripping operation, and this generally requires that it should be present in an amount of at least 5g/l.

Nitric acid is readily available commercially as a 69% by weight aqueous solution. For convenience all volume percentages of nitric acid that are stated herein are the volumes measured as 69% by weight aqueous solution.

Ferric nitrate is obtainable commercially as crystals of $Fe(NO_3)_3.9H_2O$ or as an aqueous solution containing 45% by weight of anhydrous $Fe(NO_3)_3$. For convenience all the volume percentages of ferric nitrate that are stated herein are the volumes measured as 45% by weight aqueous solution.

Naturally the invention is not restricted to using these particular starting materials and the same results can be achieved by using alternative starting materials that will provide the same active ingredients in the composition. In particular, if ferric nitrate is introduced as crystals or if ferric nitrate and/or nitric acid is introduced as a solution having a concentration different from the quoted concentrations, the figures stated herein for the 69 and 45% solutions can readily be converted to the figures appropriate for these other starting materials.

Sulphamic acid is sold commercially as an anhydrous powder. Since the sulphamic acid acts as an inhibitor rather than as an active dissolving agent for tin and solder its weight or volume can be lumped with that of the diluent water, for instance in the figures set out in Table 1 below.

The removal of solder, which constitutes the principal amount of material removed, is accomplished by a reaction between the nitric acid and the metals lead and tin of the solder. During this reaction, the sulphamic acid serves as an inhibitor to prevent the nitric acid from attacking the intermetallic tin-copper alloy or the underlying copper. The ferric nitrate is not exhausted during the dissolution of the relatively thick solder layer. However, the ferric nitrate does react with the tin-copper film and then with the underlying copper substrate. The amount of the pure copper removed is controlled by controlling the time during which the board is exposed to the solution. Typically the time is in the order of 30 seconds to one minute. While the sulphamic acid inhibits the activity of the nitric acid, it does not inhibit the ferric nitrate. It has been found that these three ingredients can be maintained successfully in a single aqueous solution and will achieve the successive stripping operations.

The concentration of sulphamic acid in the solution is not critical provided there is enough present to react with and eliminate any nitrous acid that may be present in the original nitric acid of the composition or that may be generated by chemical reactions taking place during the solder stripping and copper etching processes. The lower limit of sulphamic acid concentration for a non-replenishable system that is commercially practicable may be placed at about 5 grams per litre (gm/l). The upper limit can approach the solubility of sulphamic acid in the stripping solution.

During the stripping operation, the nitric acid is consumed, and there is a buildup of lead nitrate and tin compounds in the stripping solution.

In a typical commercial installation, the boards to be stripped are transported by conveyor through a spray booth having one or more spray heads. The stripping solution is continuously recirculated from the sump of the booth to the spray heads. The speed of the conveyor is varied to obtain the desired removal of the material from the board. In time the efficiency of the stripping solution is reduced, the time required for removal of the solder film increases, and the conveyor speed is reduced. When the time required for removal becomes too long for economical operation, the stripping solution in the booth is replaced by a fresh quantity of stripping solution. This replacement may occur weekly or daily or at shorter intervals, depending upon the size of the booth, the amount of material to be removed and the product rate.

It would be possible, but perhaps inconvenient in plant practice, to start a batch of solder stripper with a sulphamic acid concentration lower than bout 5 gm/l and to make additions of sulphamic acid as needed to suppress the formation of appreciable quantities of nitrous acid. For practical solder stripping solutions, concentrations of sulphamic acid from 5 gm/l to 70 gm/l are adequate.

The concentration of nitric acid, for practical purposes, is limited on the high side by possible damage to printed circuit board substrates and to the equipment in which the solder stripping solutions are used. It has been found that there is no practical need to exceed concentrations of nitric acid higher than about 50 volume percent of nitric acid and higher concentrations may result in fuming and in attacking the printed circuit substrate or the apparatus used for the process. Concentrations considerably less than 40 volume percent yield useful solder stripping solutions.

The concentration of nitric acid is limited on the low side by the time that may be allotted for the solder stripping operation and by the total amount of solder a given volume of solder stripping may be expected to strip before it becomes spent. ·If neither of these considerations is of importance, the nitric acid content can be as low as 5 volume percent of nitric acid or. less and still effectively strip solder from copper.

However, the concentration of nitric acid is an important factor in determining the rate at which the solder is stripped. If the economic factors dictate that, for example, approximately 0.008mm thick electroplated solder is to be consistently stripped in less than one minute at 27°C, the concentration of nitric acid should be at least about 10 volume percent of nitric acid provided that the ferric nitrate concentration is about 5 volume percent of ferric nitrate. The porosity of metal to be removed, the thickness of the metal and its position on the board and the age of the board also are factors which affect the time required to clean the board.

With nitric acid in the range of about 15 to 20 volume percent of nitric acid and at room temperature or slightly above, a concentration of ferric nitrate of 17 volume percent will yield a solution that can strip a typical 0.008mm thick film of electroplate solder and remove the intermetallic tin-copper alloy layer in about one half minute. Lower concentrations of ferric nitrate result in more time required to strip the solder and remove the intermetallic layer, and higher concentrations can reduce the time to as little as 15 to 20 seconds.

The preferred ranges for the three functional components of the stripper are about:
Nitric Acid - 5 to 50 volume percent of 69% nitric acid aqueous solution,
Ferric Nitrate - 1 to 50 volume percent of 45% ferric nitrate aqueous solution, and
Sulphamic Acid - 5 gm/l to struation,
with the balance water.
The more preferred ranges are about:
Nitric Acid - 10 to 35 volume percent of 69% nitric acid aqueous solution,
Ferric Nitrate - 5 to 25 volume percent of 45% ferric nitrate aqueous solution, and
Sulphamic Acid - 5 to 70 gm/l or saturation.
The presently preferred specific composition range is:
Nitric Acid - 15 to 30 volume percent of 69% nitric acid aqueous solution,
Ferric Nitrate - 15 to 20 volume percent of 45% ferric nitrate aqueous solution, and
Sulphamic Acid - 50 gm/l to saturation.

Effective amounts of the ingredients are, to some extent, interdependent. If, in any particular process, a composition is found to give inadequate stripping, or to strip too slowly, effective results may be obtainable by increasing the temperature or by increasing the concentration of nitric acid and/or ferric nitrate. Although useful results can in some instances be obtained at lower concentrations, it is generally preferred that the amount of nitric acid should be at least 10%. It is also generally preferred that the amount of nitric acid (measured as 69% weight percent solution) and the amount of ferric nitrate (measured as 45% by weight solution) should account for at least 20% by volume of the solution. Thus the amount of sulphamic acid and water additional to that which is provided by 69% nitric acid and 45% ferric nitrate solutions is preferably below 80% by volume.

We find that the concentrations and conditions required for stripping solder are approximately the same as those required for stripping tin.

The stripping compositions used in the invention are applied in a single step, usually by spraying, and are stable both when in storage and in use. They can provide complete solder stripping and alloy stripping in relatively short and economic time and may be used at ambient temperature without necessitating temperature control such as heating or cooling. In addition to providing the convenience of a single stage, the solutions can reduce the toxicity problems encountered with other stripping solutions.

The following are some examples.

The composition was applied in each instance by continuously spraying on to the printed circuit board as the board. In an alternative method the board could be dipped into a bath of the composition. Cleaning by dipping usually takes more time for the same board and solution.

Tests were conducted by spray-etching samples of solder plated and tin-plated printed circuit boards while varying the concentrations of 45% ferric nitrate solution and 69% nitric acid solution over a wide range. It was not considered necessary to vary the concentration of sulphamic acid since its function remains constant over a wide range of concentration.

The samples of solder-plated copper were obtained from a local printed circuit shop. The thickness of the solder plate was nominally 0.0064mm and the composition of the solder nominally 60% tin - 40% lead. After being solder plated the samples had been subjected to plating-resist stripping, copper etching and solder conditioning. The samples were about four months old.

The samples of tin-plated copper were also obtained from a local manufacturer of printed circuits. The thickness of the tin was nominally 0.005mm. The tin-plated samples had received no processing after tin plating except rinsing and drying. These samples were about two weeks old.

Test coupons about 76mm x 101mm were exposed to the solder stripping solutions in a Dynamil VRP 50 etching machine manufacturered by Western Technology Inc. All tests were conducted at ambient temperature. Stripping times were observed visually. Duplicate tests were visually run on the solder samples; one test was run on the tin samples for each composition test.

Data from the experiments were plotted on three-component graphs to determine the effective concentration ranges for ferric nitrate and nitric acid. Since the time required for stripping solder or tin is a key factor in determining the utility of a stripper, three time intervals were chosen as significant, (1) times of about 30 seconds or less, (2) times of about 30 seconds to one minute, and (3) times greater than about one minute. Solder stripper solutions that required 30 seconds or less would be acceptable commercially. Solutions requiring between 30 seconds and about one minute, although workable, would be less acceptable. Solutions requiring more than about one minute and especially those that resulted in patchy or incomplete removal of the solder or tin plate would not be acceptable.

Table 1 sets out the results of a series of tests carried out to determine suitable limits for the stripping composition of the invention. Examples 1-7 below were taken from Table 1, except for the test of Example 2 on 0.02mm thick solder plate. In the table, the amounts of the components are converted to volume percent.

TABLE 1.

| 45% Ferric Nitrate Soln. ml. | 69% Nitric Acid Soln. ml. | 190 gm Sulfamic Acid + Water ml. | Total Volume ml. | Vol % Ferric Nitrate Soln. | Vol % Nitric Acid Soln. | Vol % Sulfamic Acid + Water | Removal Time of .00025" 60/40 solder min:sec | Removal Time of .0002" tin min:sec | Temp °F | Remarks |
|---|---|---|---|---|---|---|---|---|---|---|
| **Run #1** | | | | | | | | | | |
| 757 | 0 | 2273 | 3030 | 25.0 | 0 | 75.0 | 1:30-2:00 | | 83 | patchy residue |
| 757 | 38 | 2273 | 3068 | 24.7 | 1.3 | 74.0 | 1:15-1:30 | | 84 | patchy residue |
| 757 | 76 | 2273 | 3106 | 24.4 | 2.4 | 73.2 | 1 - 1:30 | | 84 | removal complete |
| 757 | 190 | 2273 | 3220 | 23.5 | 5.9 | 70.6 | 1 | | 85 | removal complete |
| 757 | 380 | 2273 | 3410 | 22.2 | 11.1 | 66.7 | 0:30 | | 85 | removal complete |
| 757 | 570 | 2273 | 3600 | 21.0 | 15.8 | 63.2 | 0:20 | | 86 | removal complete |
| **Run #2** | | | | | | | | | | |
| 0 | 946 | 2082 | 3028 | 0 | 31.2 | 68.8 | does not remove inter-metallic layer | | 85 | |
| 38 | 946 | 2082 | 3066 | 1.2 | 30.9 | 67.9 | 1:15 | | 85 | complete removal |
| 76 | 946 | 2082 | 3104 | 2.4 | 30.5 | 67.1 | 0:40 | | 86 | complete removal |
| 114 | 946 | 2082 | 3142 | 3.6 | 30.1 | 66.3 | 0:32 | | 86 | complete removal |
| 190 | 946 | 2082 | 3218 | 5.9 | 29.4 | 64.7 | 0:24 | | 87 | complete removal |
| 380 | 946 | 2082 | 3408 | 11.1 | 27.8 | 61.1 | 0:19 | | 87 | complete removal |
| 760 | 946 | 2082 | 3788 | 20.0 | 25.0 | 55.0 | 0:15 | | 88 | complete removal |
| **Run #3** | | | | | | | | | | |
| 38 | 380 | 2648 | 3066 | 1.2 | 12.4 | 86.4 | 3:20 | | 78 | incomplete removal |
| 76 | 380 | 2648 | 3104 | 2.5 | 12.2 | 85.3 | 1:40 | | 78 | incomplete removal |
| 114 | 380 | 2648 | 3142 | 3.6 | 12.1 | 84.3 | 1:10 | | 78 | incomplete removal |
| 190 | 380 | 2648 | 3218 | 5.9 | 11.8 | 82.3 | 1:10 | | 78 | incomplete removal |
| **Run #4** | | 169 gms Sulfamic Acid + water ml. | | | | | | | | |
| 757 | 1022 | 2006 | 3785 | 20.0 | 27.0 | 53.0 | 0:19 | 0:08 | 80 | removal complete |
| 757 | 1022 | 3899 | 5678 | 13.3 | 18.0 | 68.7 | 0:35 | 0:15 | 80 | removal complete |
| 757 | 1022 | 5791 | 7570 | 10.0 | 13.5 | 76.5 | 1:45 | 0:54 | 80 | removal complete |
| 757 | 1022 | 7684 | 9463 | 8.0 | 10.8 | 81.2 | 1:45 | 1:20 | 80 | removal incomplete |

TABLE 1. (continued)

| 45% Ferric Nitrate Soln. ml. | 69% Nitric Acid Soln. ml. | 169 gm Sulfamic Acid + Water ml. | Total Volume ml. | Vol % Ferric Nitrate Soln. | Vol % Nitric Acid Soln. | Vol % Sulfamic Acid + Water | Removal Time of .00025" 60/40 solder min:sec | Removal Time of .0002" tin min:sec | Temp °F | Remarks |
|---|---|---|---|---|---|---|---|---|---|---|
| **Run #5** | | | | | | | | | | |
| 454 | 1173 | 2006 | 3633 | 12.5 | 32.3 | 55.2 | 0:16 | 0:06 | 80 | complete removal |
| 454 | 1173 | 3899 | 5526 | 8.2 | 21.2 | 70.6 | 0:26 | 0:11 | 80 | complete removal |
| 454 | 1173 | 5791 | 7418 | 6.1 | 15.8 | 78.1 | 0:45 | 0:25 | 80 | complete removal |
| 454 | 1173 | 7684 | 9311 | 4.9 | 12.6 | 82.5 | 1:10 | 0:55 | 80 | complete removal |
| 454 | 1173 | 9576 | 11203 | 4.0 | 10.5 | 85.5 | 1:56 | 1:57 | 80 | incomplete removal |
| **Run #6** | | | | | | | | | | |
| 908 | 587 | 2138 | 3633 | 25.0 | 16.2 | 58.8 | 0:30 | 0:17 | 78 | complete removal |
| 908 | 587 | 4031 | 5526 | 16.4 | 10.6 | 73.0 | 1:15 | 0:53 | 78 | removal incomplete of solder |
| 908 | 587 | 5923 | 7418 | 12.3 | 7.9 | 79.8 | 2:30 | 1:53 | 78 | removal incomplete of solder |
| **Run #7** | | 190 gm Sulfamic Acid + Water ml. | | | | | | | | |
| 1135 | 1135 | 1515 | 3785 | 30.0 | 30.0 | 40.0 | 0:26 | 0:06 | 79 | complete removal |
| 1135 | 1135 | 2461 | 4731 | 24.0 | 24.0 | 52.0 | 0:17 | 0:06 | 79 | complete removal |
| 1135 | 1135 | 3407 | 5677 | 20.0 | 20.0 | 60.0 | 0:20 | 0:12 | 80 | complete removal |
| 1135 | 1135 | 4353 | 6623 | 17.1 | 17.1 | 65.8 | 0.29 | 0:14 | 80 | complete removal |
| 1135 | 1135 | 5300 | 7570 | 15.0 | 15.0 | 70.0 | 0:34 | 0:21 | 80 | complete removal |
| 1135 | 1135 | 6246 | 8516 | 13.3 | 13.3 | 73.4 | 0:40 | 0:35 | 80 | complete removal |
| 1135 | 1135 | 7192 | 9462 | 12.0 | 12.0 | 76.0 | 0:67 | 0:45 | 80 | complete removal |
| 1135 | 1135 | 8138 | 10408 | 10.9 | 10.9 | 78.2 | 1:10 | 0:54 | 80 | removal incomplete of solder |
| **Run #8** | | | | | | | | | | |
| 1892 | 378 | 1515 | 3785 | 50.0 | 10.0 | 40.0 | 0:28 | 0:33 | 76 | complete removal |
| 1892 | 378 | 2461 | 4731 | 40.0 | 8.0 | 52.0 | 0:59 | 0:60 | 76 | complete removal |
| 1892 | 378 | 3407 | 5677 | 33.3 | 6.7 | 60.0 | 2:00+ | 1:18 | 76 | removal incomplete of solder |

0 257 792

TABLE 1. (continued)

| 45% Ferric Nitrate Soln. ml. | 69% Nitric Acid Soln. ml. | 190 gm Sulfamic Acid + Water ml. | Total Volume ml. | Vol % Ferric Nitrate Soln. | Vol % Nitric Acid Soln. | Vol % Sulfamic Acid + Water | Removal Time of .00025" 60/40 solder min:sec | Removal Time of .0002" tin min:sec | Temp °F | Remarks |
|---|---|---|---|---|---|---|---|---|---|---|
| Run #9 | | | | | | | | | | |
| 378 | 1892 | 1515 | 3785 | 10.0 | 50.0 | 40.0 | 0:34 | 0:14 | 76 | complete removal |
| 378 | 1892 | 2461 | 4731 | 8.0 | 40.0 | 52.0 | 0:27 | 0:16 | 82 | complete removal |
| 378 | 1892 | 3407 | 5677 | 6.7 | 33.3 | 60.0 | 0:25 | 0:14 | 82 | complete removal |
| 378 | 1892 | 4353 | 6623 | 5.7 | 28.6 | 65.7 | 0:23 | 0:15 | 82 | complete removal |
| 378 | 1892 | 5300 | 7570 | 5.0 | 25.0 | 70.0 | 0:33 | 0:17 | 82 | complete removal |
| 378 | 1892 | 6246 | 8516 | 4.4 | 22.2 | 73.4 | 0:42 | 0:27 | 82 | complete removal |
| 378 | 1892 | 7192 | 9462 | 4.0 | 20.0 | 76.0 | 0:46 | 0:32 | 82 | complete removal |
| 378 | 1892 | 8138 | 10408 | 3.6 | 18.2 | 78.2 | 0:54 | 0:34 | 82 | complete removal |
| 378 | 1892 | 9085 | 11355 | 3.3 | 16.7 | 80.0 | 1:14 | 0:46 | 82 | complete removal |
| 378 | 1892 | 10031 | 12301 | 3.1 | 15.4 | 81.5 | 1:20 | 1:03 | 82 | complete removal |
| 378 | 1892 | 10977 | 13247 | 2.8 | 14.3 | 82.9 | 1:33 | 1:30 | 82 | complete removal |

## Example 1 (Run 1)

757ml of 45% ferric nitrate solution, 380ml of 69% nitric acid solution and 190gms of sulphamic acid were dissolved in sufficient water to bring the total volume to 3410ml. At 30°C, 0.0064mm thickness of electroplated solder was stripped in 30 seconds. There were no solder residues left on the exposed copper surface. Acceptable performance.

## Example 2 (Run 2)

380ml of 45% ferric nitrate solution, 946ml of 69% nitric acid solution and 190gms of sulphamic acid were dissolved in enough water to bring the total volume to 3408ml. At 31°C it required 10 seconds to strip 0.0064mm thick solder plate and 25 seconds to srip 0.02mm thick solder plate from copper. Acceptable performance.

## Example 3 (Comparison) (Run 2)

946ml of 69% nitric acid and 190gm of sulphamic acid were dissolved in enough water to bring the total volume to 3028ml. After exposing a sample of copper electroplated with 0.0064mm thick solder to a spray of this solution at 30°C for three minutes the underlying copper was not exposed. Unacceptable performance as a one step stripper.

## Example 4 (Run 5)

454ml of 45% ferric nitrate solution, 1173ml of 69% nitric acid solution and 169gms of sulphamic acid were dissolved in sufficient water to bring the total volume to 3633ml. At 27°C, 0.0064mm of solder was stripped from a copper substrate in 16 seconds; 0.005mm of tin was stripped in 6 seconds at 27°C. Removal of the electroplated film was complete. Acceptable performance.

## Example 5 (Run 9)

378ml of 45% ferric nitrate solution, 1892ml of 69% nitric acid solution and 190gms of sulphamic acid were dissolved in sufficient water to bring the total volume to 7570ml. At 82°F it required 33 second to strip the solder 0.0064mm thick and it required 17 seconds to strip tin 0.005mm thick. Acceptable performance.

## Example 6 (Run 7)

1135ml of 45% ferric nitrate solution, 1135ml of 69% nitric acid solution and 190gms of sulphamic acid were dissolved in enough water to bring to total volume to 9462ml at 28°C it required 67 second to strip a film of electroplated solder 0.0064mm thick from copper. It requied 45 seconds at 28°C to strip a 0.005mm thick film of electroplated tin from copper. Barely acceptable performance.

## Claims

1. A composition for removal of solder from the copper substrate of a printed circuit board and comprising an aqueous solution of nitric acid, characterised in that the composition also removes the underlying tin-copper alloy from the copper substrate and the solution also contains ferric nitrate and sulphamic acid.

2. A composition according to claim 1 that is an aqueous solution of nitric acid in an amount of 5 to 50 volume percent measured as 69% by weight aqueous nitric acid solution, ferric nitrate in an amount of 1 to 50 volume percent measured as 45% aqueous ferric nitrate solution, and at least 5g/l sulphamic acid.

3. A composition according to claim 1 or claim 2 in which the amount of nitric acid is at least 10% by volume measured as 69% aqueous solution.

4. A composition according to claim 1 that is an aqueous solution of nitric acid in an amount of 10 to 35 volume percent measured as 69% aqueous solution, ferric nitrate in an amount of 5 to 25 volume percent measured as 45% aqueous solution, and 5 to 75g/l sulphamic acid.

5. A composition according to claim 1 that is an aqueous solution of nitric acid in an amount of 15 to 30 volume percent measured as 69% aqueous solution, ferric nitrate in an amount of 15 to 20 volume percent measured as 45% aqueous solution, and at least 5g/l sulphamic acid.

6. A composition according to any of claims 1 to 4 in which the volume of nitric acid, measured as 69% by weight aqueous solution, and ferric nitrate, measured as 45% by weight aqueous solution, is at least 20% by volume of the composition.

7. A process for stripping solder and the underlying tin-copper alloy from the copper substrate of a printed circuit board by applying a stripping composition, characterised in that the stripping composition is a composition according to any preceding claim.

8. A method according to claim 7 in which the composition is applied by spraying.